# EUROPEAN PATENT SPECIFICATION

(11) **EP 3 829 968 B1**
(45) Date of publication and mention of the grant of the patent: **26.04.2023**
(21) Application number: 19766397.4
(22) Date of filing: 28.08.2019
(51) Int. Cl.: B29C 59/04, B81C 99/00

(54) **METHOD FOR PRODUCING AN AIR-RETAINING FILM WITH TEXTURED SURFACE, AND AN AIR-RETAINING FILM WITH TEXTURED SURFACE**
VERFAHREN ZUR HERSTELLUNG EINES LUFTHALTEFILMS MIT STRUKTURIERTER OBERFLÄCHE SOWIE LUFTHALTEFILM MIT STRUKTURIERTER OBERFLÄCHE
PROCÉDÉ DE PRODUCTION D'UN FILM RETENANT L'AIR AVEC UNE SURFACE TEXTURÉE ET FILM RETENANT L'AIR AVEC UNE SURFACE TEXTURÉE

(30) Priority: 30.08.2018 EP 18191808
(43) Date of publication of application: 09.06.2021
(73) Proprietor: Avery Dennison Corporation, Mentor, OH 44060 (US)
(72) Inventor: CAVUSOGLU, Mutlu, 1349 CM, Almere (NL); PEROTTI, Daniele, 6020 Dampremy (BE); MINOR, Jean-Christophe, 7830 Bassilly (BE)
(74) Representative: D Young & Co LLP
(86) International application number: PCT/US2019/048503
(87) International publication number: WO 2020/047052

(56) References cited:
- EP-A1- 3 330 326
- DE-A1-102015 104 257
- US-A1- 2005 258 570
- US-A1- 2013 040 073
- US-A1- 2018 016 444
- US-B2- 9 630 373

## Description

### TECHNICAL FIELD

The present invention relates to a method for producing an air-retaining film with textured surface, and to an air-retaining film with textured surface.

### BACKGROUND

Structures having underwater surfaces or surfaces in contact with water, such as ships and liquid transport channels, produce a flow of water along their surfaces as the ships travel or liquid moves, with the relative velocity of water being zero at the submerged surface of the structure. A velocity gradient near the structure's submerged surface depends on the viscosity of fluid and the shearing forces due to viscosity constitute the fluid frictional drag.

This fluid frictional drag experienced by the ship can be very large. Of the drags exerted on the ship as it navigates, which include a wave-making drag, a form drag and an air drag in addition to the fluid frictional drag, the fluid frictional drag accounts for as much as 60 to 70% of the total drag or resistance.

Considering such a large proportion of the fluid frictional drag, the best way to economize the propelling power and increase the speed of a ship is to minimize the fluid frictional resistance and the development of such a technology has been strongly called for in the industry. Another problem related to fluid frictional drag, is the presence of fouling, such as barnacles, mussels, moss animals, green algae, etc., on underwater structures. Fouling on a ship's underwater surfaces increases fluid frictional drag.

One way of drag reduction is coating a ship's underwater surface with a film entrapping air. Coating of underwater structures with such films is known from the prior art.

US9630373B2 discloses a method for protecting a body that is placed in contact with a liquid, said method comprising arranging a gas-retaining layer on at least a portion of a body that can be immersed in a liquid or wetted by a liquid and which is in contact by way of a liquid-facing side with a liquid when the body is immersed in/wetted by the liquid, wherein the gas-retaining layer has on the liquid-facing side recesses and/or protruding elements whose surfaces are hydrophobic at least regionally, and a gas layer which is retained in the immersed/wetted region of the gas-retaining layer separates the liquid and the immersed/wetted region of the body from one another at least regionally, wherein the gas-retaining layer is divided into a multiplicity of sub-regions by fluid-impermeable partitions. US9630373B2 does not provide a method for the production of large-area gas-retaining layers. Additionally, the structure of said liquid-facing side disclosed in US9630373B2 could be optimized to improve gas-retention. Documents EP 3 330 326 A1, US 2013/040073 A1, US 9 630 373 B2, DE 10 2015 104257 A1, US 2018/016444 A1 and US 2005/258570 A1 constitute further relevant prior art.

The present invention aims to resolve at least some of the problems mentioned above.

### SUMMARY OF THE INVENTION

In a first aspect, the invention provides a method for producing an air-retaining film with textured surface, according to claim 1.

Using a removable polymeric film comprising an embossed surface for providing a surface morphology of the air-retaining layer comprising protruding elements promotes a stable formation of said protruding elements while shielding the protruding elements from an environment until the air-retaining film with textured surface is prepared for use by removing the removable polymeric film. This ensures a well-defined formation of protruding elements and a highly textured surface morphology of the air-retaining layer which is beneficial for reasons of drag reduction and fouling release. The highly textured surface morphology of the air-retaining layer by providing the protruding elements on the air-retaining layer, together with the, at least regionally, hydrophobic nature of the protruding elements is especially suitable for trapping and retaining air between the protruding elements, the entrapped air forming an air layer which keeps a liquid, e.g. water, from coming into contact with the air-retaining film and thus with a ship, vessel or similar substrate to be coated with the air-retaining film, and thus provides the air-retaining film with drag reduction and fouling release properties. Furthermore, said method enables large-area production of the air-retaining film comprising the air-retaining layer with protruding elements,

In a second aspect, the invention provides an air-retaining film with textured surface, according to claim 7.

Such dimensions and spacing of the protruding elements of the silicone air-retaining layer, together with the, at least regionally, hydrophobic nature of the protruding elements is especially suitable for trapping and retaining air between the protruding elements, the entrapped air forming an air layer which keeps a liquid, e.g. water, from coming into contact with the air-retaining film and thus with a ship, vessel or similar substrate to be coated with the air-retaining film, and thus providing the air-retaining film with drag reduction and fouling release properties.

In a third aspect, the invention provides an air-retaining film with textured surface, wherein the protruding elements are compartmentalized or grouped by surrounding walls. The height of these walls must have the same height than the protruding elements to avoid drag increase. These surrounding walls can have a regular or irregular closed pattern. This compartmentalization of the protrusions provides for an additional air-retaining effect especially in sea-circumstances and at higher velocity of the vessels,

### DESCRIPTION OF FIGURES

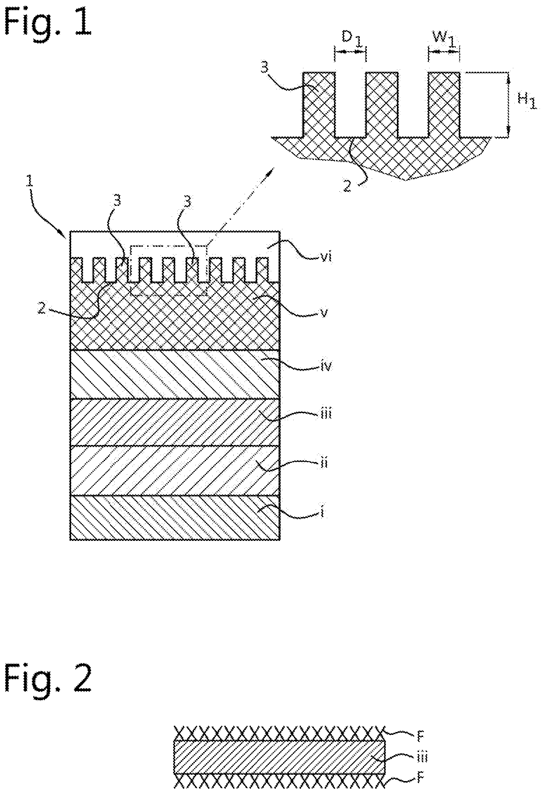

Fig. 1 is a schematic sectional view of an air-retaining film with textured surface, according to embodiments of the invention, wherein the decreasing height of adjacent protruding elements along a rectilinear direction is not shown.
Fig. 2 is a schematic sectional view of a synthetic material layer having functional groups on both its surfaces to increase the surface energy, according to embodiments of the invention.

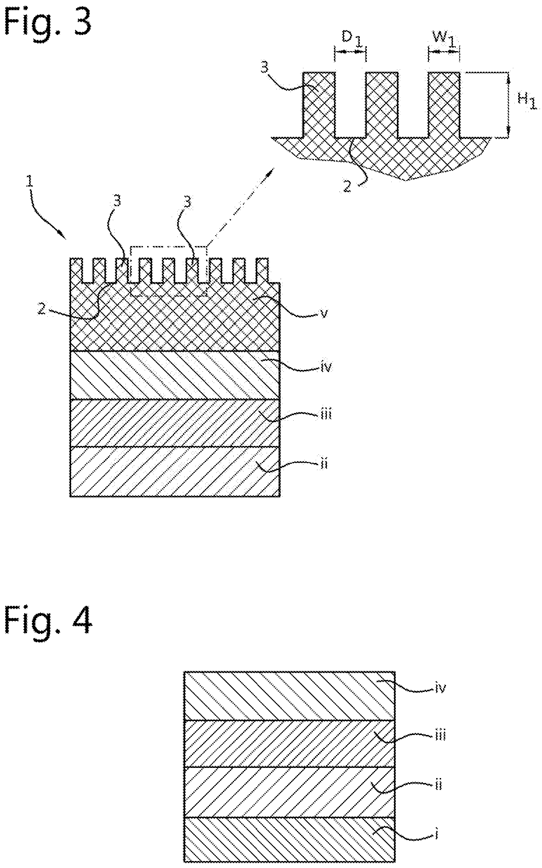

Fig. 3 is a schematic sectional view of an air-retaining film with textured surface which is ready to be applied on a substrate, according to embodiments of the invention, wherein the decreasing height of adjacent protruding elements along a rectilinear direction is not shown.
Fig. 4 is a schematic sectional view of a part of an air-retaining film with textured surface which is wound after coating of an intermediate silicone tie coat, enabling contact between a removable underlying liner and a silicone fouling release top coat, according to embodiments of the invention.

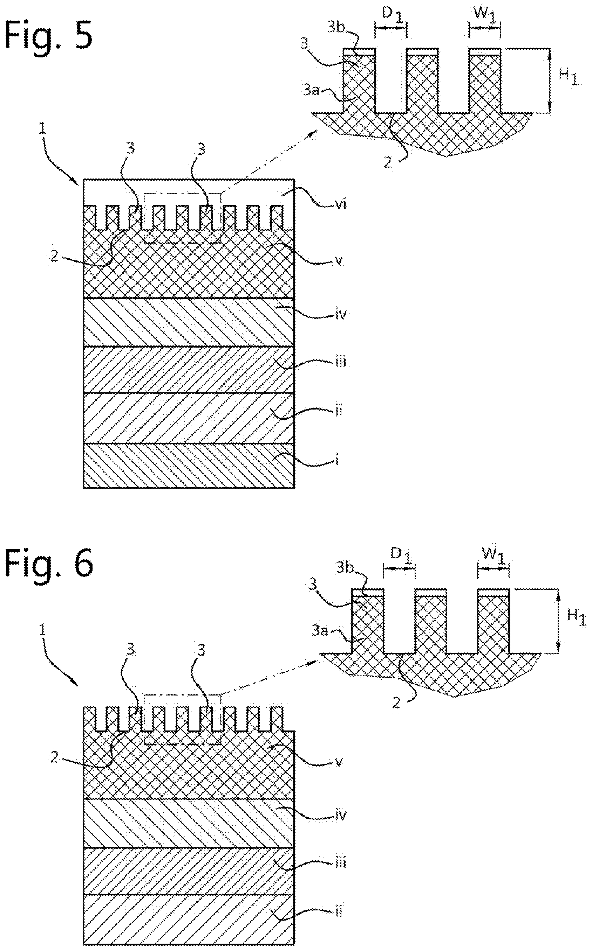

Fig. 5 is a schematic sectional view of an air-retaining film with textured surface, in which an air-retaining layer is provided with protruding elements comprising hydrophobic bodies and hydrophilic ends, according to embodiments of the invention, wherein the decreasing height of adjacent protruding elements along a rectilinear direction is not shown.
Fig. 6 is a schematic sectional view of an air-retaining film with textured surface, in which an air-retaining layer is provided with protruding elements comprising hydrophobic bodies and hydrophilic ends, and which air-retaining film is ready to be applied on a substrate, according to embodiments of the invention, wherein the decreasing height of adjacent protruding elements along a rectilinear direction is not shown.

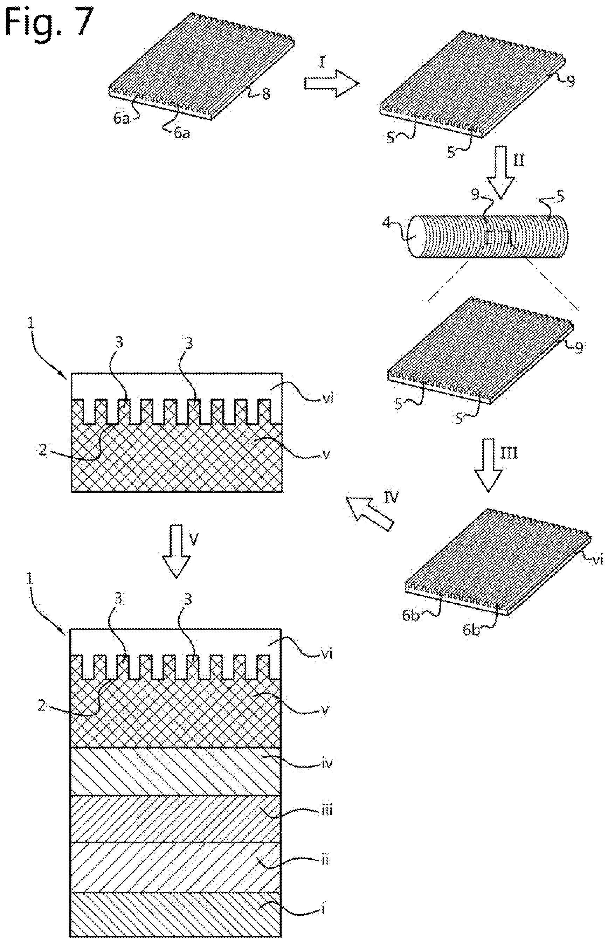

Fig. 7 is a schematic representation of method steps for producing an air-retaining film with textured surface, according to embodiments of the invention, wherein the decreasing height of adjacent protruding elements along a rectilinear direction is not shown.

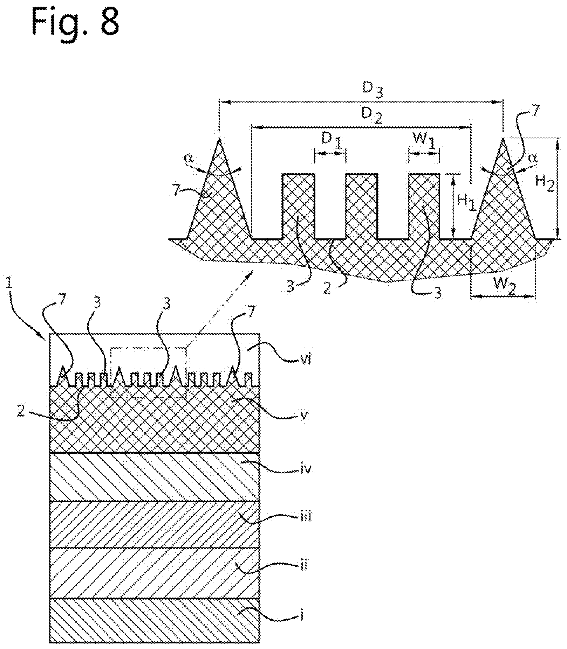

Fig. 8 is a schematic sectional view of an air-retaining film with textured surface, in which an air-retaining layer is provided with protruding elements and ribs provided in between the protruding elements, according to embodiments of the invention, wherein the decreasing height of adjacent protruding elements along a rectilinear direction is not shown.

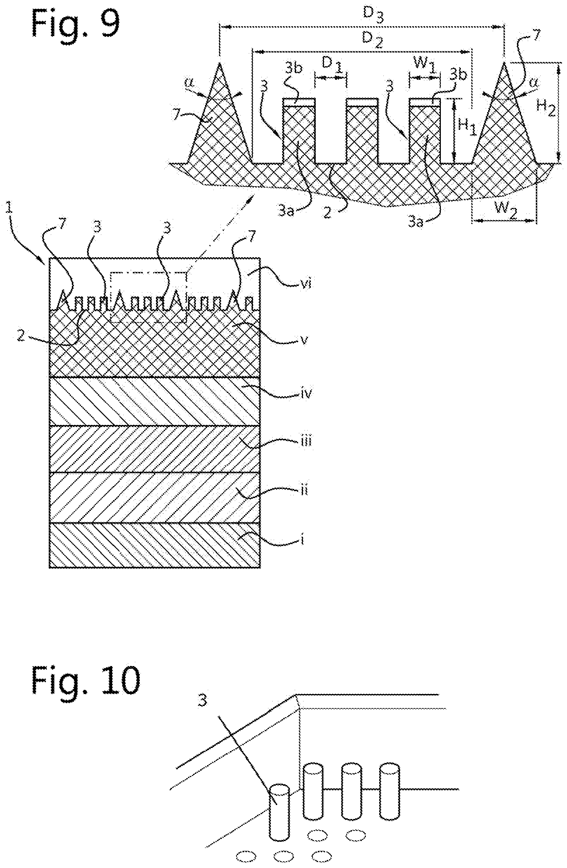

Fig. 9 is a schematic sectional view of an air-retaining film with textured surface, in which an air-retaining layer is provided with protruding elements and ribs provided in between the protruding elements, and in which the protruding elements comprise hydrophobic bodies and hydrophilic ends, according to embodiments of the invention, wherein the decreasing height of adjacent protruding elements along a rectilinear direction is not shown.

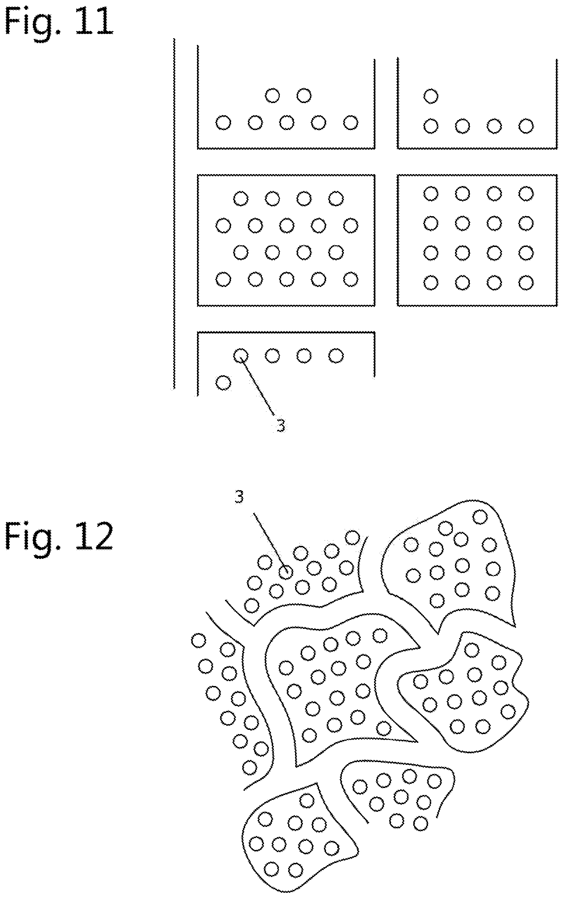

Fig. 10 is a schematic perspective view, Fig.11 and Fig. 12 are schematic top views of an air-retaining film with textured surface, in which an air-retaining layer is provided with protruding elements and/or ribs which are compartmentalized or grouped by surrounding walls for an improved air-retaining.

### DETAILED DESCRIPTION OF THE INVENTION

As used herein, the expression "applied over and to" means that layers are joined together, that is, are directly in contact with each other.

In a first aspect, the invention provides a method for producing an air-retaining film, the air-retaining film comprising an air-retaining layer provided with a liquid-facing side to be contacted with liquid in use, the liquid-facing side comprising a surface morphology with spaced protruding elements whose surfaces are hydrophobic at least regionally, wherein the method comprises the step of laminating an embossed surface of an embossed removable polymeric film onto a side of an at least regionally hydrophobic curable material layer which is at a liquid or semi-cured stage, wherein said embossed surface is a negative of the surface morphology of the liquid-facing side of the air-retaining layer to be produced, the lamination step shaping the curable material layer into an air-retaining layer with a liquid-facing side comprising said surface morphology. Preferably, the protruding elements are arranged with regard to each other and of such dimensions to enable air to be trapped and retained when the air-retaining layer is immersed and subject to flow in a liquid,

Using a removable polymeric film comprising an embossed surface for providing a surface morphology of the air-retaining layer comprising protruding elements promotes a stable formation of said protruding elements while shielding the protruding elements from an environment until the air-retaining film with textured surface is prepared for use by removing the removable polymeric film. This ensures a well-defined formation of protruding elements and a highly textured surface morphology of the air-retaining layer which is beneficial for reasons of drag reduction and fouling release. The highly textured surface morphology of the air-retaining layer by providing the protruding elements on the air-retaining layer, together with the, at least regionally, hydrophobic nature of the protruding elements is especially suitable for trapping and retaining air between the protruding elements, the entrapped air forming an air layer which keeps a hydrophilic liquid, e.g. water, from coming into contact with the air-retaining film and thus with a ship, vessel or similar substrate to be coated with the air-retaining film, and thus provides the air-retaining film with drag reduction and fouling release properties. Furthermore, said method enables large-area production of the air-retaining film comprising the air-retaining layer with protruding elements. The method according to the present invention is not to be regarded as obvious for a person skilled in the art, since such person would rather try to optimize the smoothness of a fouling release coating to get the combined effect.

In a preferred embodiment the invention provides a method for producing an air-retaining film with textured surface according to the first aspect of the invention, wherein said at least regionally hydrophobic curable material layer comprises silicone and/or silicone derivatives. Silicone and/or silicone derivatives show the advantage to have a high flexibility, allowing the formation of protruding elements, which are preferably arranged with regard to each other and of such dimensions to enable air to be trapped and retained when the air-retaining layer is immersed and subject to flow in a liquid, in the resulting air-retaining layer without breaking said layer. Additionally, silicone is hydrophobic from nature and thus does not repel air which is also considered hydrophobic.

In a preferred embodiment the invention provides a method for producing an air-retaining film with textured surface according to the first aspect of the invention, wherein said embossed removable polymeric film comprises a thermoplastic or hot melt polymer, for instance a polypropylene, polyethylene or polyester film, A polypropylene, polyethylene or polyester film shows the advantages that it can be used to form the surface morphology of the liquid-facing side 2 of the air-retaining layer to be produced, and that it functions as an excellent protective layer of the air-retaining layer before it is applied on an underwater surface of a vessel, ship, or similar substrate for its drag reduction and fouling release properties.

In a preferred embodiment the invention provides a method for producing an air-retaining film with textured surface according to the first aspect of the invention, wherein before the lamination step, the method comprises the step of embossing a removable polymeric film to provide said embossed removable polymeric film, which embossing is performed by extruding the removable polymeric film on a silicone or rubber mold with a surface comprising a surface morphology which is identical to said surface morphology of the liquid-facing side of the air-retaining layer. The silicone or rubber mold shows the advantages that due to its flexibility, it is easily maneuverable and can rather easily be removed from the removable polymeric film which is embossed by it. Additionally, the silicone or rubber mold can absorb part of the energy when embossing or releasing the removable polymeric film, which avoids breaking of the removable polymeric film when being embossed.

In a preferred embodiment the invention provides a method for producing an air-retaining film with textured surface according to the first aspect of the invention, wherein said silicone or rubber mold is mounted onto a cylinder. Mounting of said silicone or rubber mold onto a cylinder has the advantage that embossing of a material by the silicone or rubber mold can be performed relatively fast by rotating the cylinder, and if desired can be relatively easy be performed in a continuous manner.

In a preferred embodiment the invention provides a method for producing an air-retaining film with textured surface according to the first aspect of the invention, wherein the method comprises the step of forming said silicone or rubber mold, which is performed by casting liquid silicone onto a metallic panel, preferably a Si metallic panel, with a surface comprising a surface morphology which is a negative of the surface morphology of the liquid-facing side of the air-retaining layer, and wherein said surface of the metallic panel is structured by lithography. A metallic panel, and especially a Si metallic panel, shows the advantage of being able to be structured very finely by lithography, which is required as a basis for finally acquiring a surface morphology of the liquid-facing side with its protruding elements, which protruding elements are preferably arranged with regard to each other and of such dimensions to enable air to be trapped and retained when the air-retaining layer is immersed and subject to flow in a liquid.

In a preferred embodiment the invention provides a method for producing an air-retaining film with textured surface according to the first aspect of the invention, wherein the method comprises the step of applying a side of the air-retaining layer opposite to the liquid-facing side over and to a self-adhesive structure. In a preferred embodiment, said self-adhesive structure is a multi-layered structure comprising:
- an optional removable underlying liner;
- an adhesive layer, applied over and to the optional underlying liner when present;
- a synthetic material layer applied over and to the adhesive layer; and
- optionally, an intermediate silicone tie coat which is a one component silicone system, a two components silicone system or a three components silicone system, applied over and to the synthetic material layer,
and wherein a side of the air-retaining layer opposite to the liquid-facing side is applied over and to the synthetic material layer, or, when present, to the intermediate silicone tie coat.

Said optional removable layer and said intermediate silicone tie coat are preferably present in the preferred embodiment mentioned above. For embodiments of the removable underlying liner, the adhesive layer, the synthetic material layer and the intermediate silicone tie coat is referred to the description below of each of these layers. The latter mentioned multilayered structure comprising said layers may be prepared according to a method comprising the steps of a) optionally, coating a removable underlying liner over and to an adhesive layer, b) coating the adhesive layer with a synthetic material layer, and c) coating the synthetic material layer with an intermediate silicone tie coat. Preferably, after performing said steps a) to c), a resulting intermediate multilayer product is put in an oven until the product is in a semi-cured stage. Preferably, the air-retaining layer, which preferably comprises silicone and/or silicone derivatives, is also provided in a semi-cured stage, after which a side of the air-retaining layer opposite to the liquid-facing side is applied over and to the synthetic material layer, or, when present, to the intermediate silicone tie coat. Subsequently, an obtained assembly of layers can be cured in an oven. The addition of the self-adhesive structure shows the advantage that the air-retaining film is provided with a well-connected adhesive layer, which adhesive layer is optimally suited for adhesion of the air-retaining film on an underwater surface of a ship, vessel, or similar substrate to be coated. If present, the removable underlying liner is to be removed prior to coating of the film with textured surface with its adhesive layer on underwater surfaces of ships, vessels or similar substrates. The removable polymeric film is to be removed once the film with textured surface has been coated on said underwater surfaces.

In a second aspect, the invention provides an air-retaining film with textured surface, the air-retaining film comprising an air-retaining layer provided with a liquid-facing side to be contacted with liquid in use, the liquid-facing side comprising a surface morphology with spaced protruding elements whose surfaces are hydrophobic at least regionally, wherein adjacent protruding elements are spaced from another according to a distance of 0.01 to 3000 µm, more preferably of 0.4 to 300 µm, even more preferably of 0.8 to 30 µm and yet even more preferably of 1 to 12 µm, wherein a protruding element has a height and a ratio of said height and said distance is from 1:3 to 3:1, more preferably from 1:1 to 2.7:1, even more preferably from 1,5:1 to 2.4:1, and yet even more preferably from 1.8:1 to 2.2,1, and wherein a protruding element has a width and a ratio of said width and said distance is from 1:3 to 3:1, more preferably from 1:2 to 2:1, even more preferably from 1:1.5 to 1,5:1, and yet even more preferably from 1:1.2 to 1.2:1.

Such dimensions and spacing of the protruding elements of the silicone air-retaining layer, together with the, at least regionally, hydrophobic nature of the protruding elements is especially suitable for trapping and retaining air between the protruding elements, the entrapped air forming an air layer which keeps a liquid, e.g. water, from coming into contact with the air-retaining film and thus with a ship, vessel or similar substrate to be coated with the air-retaining film, and thus providing the air-retaining film with drag reduction and fouling release properties. The air-retaining film according to the present invention is not to be regarded as obvious for a person skilled in the art, since such person would rather try to optimize the smoothness of a fouling release coating to get the combined effect.

In a preferred embodiment the invention provides an air-retaining film with textured surface according to the second aspect of the invention, wherein the air-retaining layer comprises silicone and/or silicone derivatives. Silicone and/or silicone derivatives show the advantage to have a high flexibility, allowing the formation of protruding elements with said heights, widths and with said distances between the protruding elements. Additionally, silicone is hydrophobic from nature and thus does not repel air which is also considered hydrophobic,

The invention provides an air-retaining film with textured surface according to the second aspect of the invention, wherein the air-retaining film comprises an embossed removable polymeric film comprising an embossed surface, which polymeric film is applied along said surface over and to the liquid-facing side of the air-retaining layer, wherein said embossed surface is a negative of the surface morphology of the liquid-facing side of the air-retaining layer. Using a removable polymeric film comprising an embossed surface for providing a surface morphology of the air-retaining layer comprising protruding elements promotes a stable formation of said protruding elements while shielding the protruding elements from an environment until the air-retaining film with textured surface is prepared for use by removing the removable polymeric film, which use implies for example coating of an underwater surface of a ship, vessel, or a similar substrate with the air-retaining film,

The invention provides an air-retaining film with textured surface, wherein within the surface morphology of the liquid-facing side of the air-retaining layer, the height of adjacent protruding elements decreases along a rectilinear direction. This is advantageous for large-area air-retaining layers to be applied onto an underwater surface of a ship, vessel, or a similar substrate, since the protruding elements undergo higher forces when immersed deeper in a liquid, e.g. water, thus necessitating decreasing heights of protruding elements for such air-retaining layers.

The invention provides an air-retaining film with textured surface according to the second aspect of the invention, wherein the air-retaining layer and/or the embossed removable polymeric film are obtained by performing a method according to the first aspect of the invention. Accordingly, all technical achievements and positive features of the method according to the first aspect of the present invention are combined with those of the air-retaining film according to the second aspect of the present invention.

In a preferred embodiment the invention provides an air-retaining film with textured surface according to the second aspect of the invention, wherein one or more of said protruding elements comprise a hydrophobic body and a hydrophilic end. Suitable materials for such air-retaining layer comprising hydrophobic bodies and hydrophilic ends are a silicone derivative with hydrophilic groups as material for the hydrophilic ends and a silicone (hydrophobic) material which forms the material for the remainder of the protruding elements. Said silicone derivative with hydrophilic groups may comprise both hydrophilic and hydrophobic groups and could be a dimethylsiloxane backbone in which some of the methyl groups are replaced by polyalkylenoxy or pyrrolidone groups with a propyl group as a spacer. Also, such silicone derivative could be used to form the protruding elements, if hydrophilic groups of such silicone derivative are located at said hydrophilic end while hydrophobic groups are located at said hydrophobic body. Since air is hydrophobic, the air prefers to reside near the hydrophobic body and away from the hydrophilic end. This will reduce the risk of losing entrapped air, and thus improves the air retention by the protruding elements.

In a preferred embodiment the invention provides an air-retaining film with textured surface according to the second aspect of the invention, wherein ribs are provided on the liquid-facing side of the air-retaining layer and in between the protruding elements, said ribs having a height, and wherein a ratio of said rib height and the height of a protruding element is at least 1,5:1, more preferably at least 1,8:1 and even more preferably at least 2:1, and most preferably at least 3:1. The ribs impair adherence of underwater organisms to the air-retaining layer, thus improving fouling release by the film and avoiding increased drag in time. At the same time, due to its structure, the textured surface morphology of the ribs itself provides an increased drag reduction.

In a preferred embodiment the invention provides an air-retaining film with textured surface according to the second aspect of the invention, wherein the air-retaining film further comprises:
- an optional removable underlying liner;
- an adhesive layer, applied over and to the optional underlying liner when present;
- a synthetic material layer applied over and to the adhesive layer; and
- optionally, an intermediate silicone tie coat which is a one component silicone system, a two components silicone system or a three components silicone system, applied over and to the synthetic material layer,
and wherein a side of the air-retaining layer opposite to the liquid-facing side is applied over and to the synthetic material layer, or, when present, to the intermediate silicone tie coat. The additional layers serve to provide the air-retaining film with an adhesion means on a side opposite to the liquid-facing side of the silicone air-retaining layer of the air-retaining film, so that the air-retaining film may be coated on an underwater surface of a ship, vessel or similar substrate without needing separately applied adhesion means.

Preferably, a rib has a height and adjacent ribs are spaced from another according to a distance, and wherein the ratio of the distance between adjacent ribs and said rib height is from 3:1 to 1:1, and more preferably from 2.5:1 to 1.5:1 and even more preferably from 2.2:1 to 1.8:1. Spacing between adjacent ribs is beneficial for drag reduction, and especially when valleys formed in spaces between adjacent ribs are generally parallel to a fluid flow. Said ratio of distance between adjacent ribs and rib height is found to be optimally suited for fouling release and drag reduction functionality of the film with textured surface. Preferably, a rib has a width and wherein rib width and rib height relate according to a ratio from 1:200 to 2:1 and more preferably from 1:50 to 1:1. Ribs dimensioned with rib widths and heights that relate according to a ratio within said range are optimally suited. Preferably, the height of a rib is from 20 to 200 µm, and more preferably from 23 to 180 µm and even more preferably from 25 to 160 µm, said rib heights are large enough to provide an additionally textured surface morphology for improving fouling release while the heights are not that large that the ribs themselves will cause a considerable drag reduction of a substrate to be coated by an air-retaining film with textured surface according to the invention, since a too large height of the ribs is negatively affecting the friction of the ribs with water. Preferably, the width of a rib is from 1 to 40 um, Such rib widths are large enough to structurally enable rib heights according to said ratio between rib width and rib height from 1:200 to 2:1. At the same time, the widths are not that large that the amount of ribs per surface area is reduced too much and/or that angles formed by the ribs are too large, resulting in suboptimal fouling release and drag reduction properties. Preferably, the distance between adjacent ribs is from 50 to 400 µm, more preferably from 55 to 350 µm and even more preferably from 60 to 310 µm. Said distances between adjacent ribs are large enough to enable drag reduction while being not too large that the spaces between adjacent ribs would form large flat-bottomed valleys where underwater organisms might settle easily. Preferably, each rib shows an opening angle of 15 to 45°, more preferably of 20 to 40° and even more preferably of 25 to 35 °. Ribs with such opening angles are sharp and therefore beneficial for providing a sufficiently additionally textured surface morphology, Smaller angles could pose problems regarding structural stability, which may negatively affect fouling release or drag reduction.

The width W₁ and height H₁ of a protruding element and the distance between adjacent protruding elements D1 as used herein is shown in figures 1, 3, 5, 6, 8 and 9, The width W₂, height H₂ and opening angle α of a rib, the distance between adjacent ribs D₂ and the top-to-top rib distance D₃ as used herein are shown in figures 8 and 9.

Each rib or protruding element has a base, representing the collection of points in the plane of the surface which the rib or protruding element protrudes. From the base emerges at least one side which converges into a top. The intersection of points between the base and the side(s) are the base angles. The plane where the rib or protruding element protrudes the surface is the base plane. Each rib or protruding element further has a top, the point or collection of points the furthest away from the base plane in which the base lies.

The distance between adjacent protruding elements D₁ is defined as the shortest distance between the base angles of two adjacent protruding elements. The distance between adjacent ribs D₂ is defined as the shortest distance between the base angles of two adjacent ribs. The top-to-top rib distance D₃ is defined as the shortest distance between the geometric center of the top of two adjacent ribs. E.g. for a flat top the geometric center (middle point) of each flat top is used.

The height of a protruding element H₁ is the distance between the base plane of said protruding element and the top of said protruding element. The width W₁ is the length of the shortest diameter connecting two base angles of said protruding element and crossing through the projection of the geometric center of the top onto the base plane.

The height of a rib H₂ is the distance between the base plane of said rib and the top of said rib. The width W₂ is the length of the shortest diameter connecting two base angles of said rib and crossing through the projection of the geometric center of the top onto the base plane.

The opening angle α of each rib is defined as the smallest angle that stretches in a plane perpendicular to the base plane, and that stretches from a base angle of the rib, to the top of said rib, to another base angle of said rib. If the top of a rib is a collection of points, then the geometric center of this collection of points is used.

In a preferred embodiment the invention provides an air-retaining film with textured surface according to the second aspect of the invention, wherein the film with textured surface is wound into a roll for storage purposes.

In embodiments, the thickness of the air-retaining film with textured surface according to the second aspect of the invention depends on the thickness of each layer in the film provided that properties claimed in the present invention are not affected. In preferred embodiments, the thickness of the film with textured surface is from 50 µm to 5000 µm, more preferably from 100 µm to 2000 µm, and even more preferably from 200 µm to 700 µm,

In preferred embodiments, the strength of adhesion of aquatic organisms onto an air-retaining film with textured surface of the present invention is 0.1 N/mm² or less, more preferably 0.01 N/mm² or less, still more preferably 0.002 N/mm² or less. The lower the strength of adhesion is between the fouling release top coat and an aquatic organism, the more efficient is the film in terms of fouling release properties. The low strength of adhesion may also be beneficial to low drag properties.

The strength of adhesion of aquatic organism onto the film may be measured with a dynamometer such as an ADEMVA DM10. The method may be as follow: apply a pressure on the aquatic organism to release it from the film.

In preferred embodiments, the air-retaining film with textured surface according to the second aspect of the invention is flexible enough to allow a good conformation to all irregular shapes of an underwater surface of an underwater structure to wrap. The flexibility may be measured by testing the tensile strength of the film at 10% elongation, according to the norm ISO 527-3/2/300. The tensile strength at 10% elongation at 23°C is 35 N/15mm or less, preferably 20 N/15mm or less, and more preferably 15 N/15 mm or less. When the tensile strength at 10% elongation is within one of these ranges, the film can be applied with satisfaction on the shapes of a substrate such as an underwater structure. A high tensile strength at 10%, elongation, being outside the above ranges, of the film may cause some lifting from the irregular underwater structure, and is therefore undesired.

The elongation at break of the air-retaining film with textured surface according to the second aspect of the invention depends on the elongation of each layer. The elongation at break of the air-retaining film with textured surface is measured according to the norm ISO 527-3/2/300. The elongation at break at 2.3 °C is preferably 1.5% or more, more preferably 50% or more. When the elongation at break is in the range, the film can be applied with satisfaction on the shapes of the underwater surface or structure and give a good re-workability during the time of application. If the elongation at break is less than 15% of elongation, the working efficiency could be reduced because of the low elongation and breaking of the film.

The tensile strength at break of the textured surface according to the second aspect of the invention depends on the elongation of each of each layer. The tensile strength at break of air-retaining film with textured surface is measured according to the norm ISO 527-3/2/300. In preferred embodiments, the tensile strength at break at 23 °C is 10 N/15 mm or more and more preferably 20 N/15 mm or more. The more the tensile strength at break is in the range, the more the film can be applied with satisfaction on the shapes of the underwater structure or surface and give a good re-workability during the time of application. If the tensile strength at break is less than 10 N/15 mm, the working efficiency could be reduced because of the fast breaking of the film, and is therefore undesired.

In preferred embodiments, the 180° peeling strength of adhesion of the air-retaining film with textured surface according to the second aspect of the invention at a speed of 300 mm/min between the adhesive layer (ii) and the underwater structure, as measured according to the Finat test method FTM 1 at 23°C, is 10 N/25 mm or more, more preferably 25 N/25 mm or more and still more preferably 40 N/25 mm or more. The higher the peeling strength is the lower is the risk to have self-lifting from a substrate coated with the film with textured surface according to the second aspect of the invention.

An air-retaining film with textured surface according to a preferred embodiment of the present invention is composed as illustrated on Fig. 1. According to this preferred embodiment and due to the materials chosen for the air-retaining layer in this embodiment, as will be described below, the air-retaining layer can also be understood as a "silicone fouling release top coat". According to this preferred embodiment, the air-retaining film with textured surface, due to its fouling release functionality besides its drag reduction functionality, can also be understood as a "multilayer self-adhesive fouling release film with textured surface." According to a preferred embodiment of the present invention, the term "applied multilayer self-adhesive fouling release film with textured surface" is used to indicate the multilayer self-adhesive fouling release film with textured surface as if ready to be applied or coated on a substrate, such as an underwater surface or structure. An "applied multilayer self-adhesive fouling release film with textured surface" according to this preferred embodiment thus comprises a layered structure as schematically shown in Fig. 3: the applied film with textured surface comprises fewer layers, since the removable underlying liner is to be removed prior to application of the multilayer film on a substrate's surface and the removable polymeric film is to be removed once the multilayer film has been applied over a surface to be coated.

In the following, embodiments are described of the different layers of the film with textured surface according to a preferred embodiment of the invention.

### Removable underlying liner

The removable underlying liner is removed prior to application of the multilayer film on a substrate's surface. In a preferred embodiment, the removable liner is present, In preferred embodiments, the removable liner is a siliconized paper or siliconized synthetic layer. In embodiments wherein the removable polymeric film layer is not comprised in the multilayer self-adhesive fouling release film with textured surface according to the invention, as in the embodiments shown in Fig. 3 and Fig. 4, the removable liner can exert two functional roles, of which the first is crucial, namely the role of a liner for the adhesive layer. Additionally, when the multilayer self-adhesive fouling release film with textured surface is wound into a roll, the removable liner also acts a protective material for the silicone tie coat or the silicone fouling release top coat.

In preferred embodiments, such removable liner is preferably a clay coated backing paper coated by an addition-type siliconized system. The clay coated paper contains a humidity rate preferably 3% and more, more preferably from 6% to 10% by weight of water. The humidity, contained in the paper, participates to the hydrolysis of the acetate ion, CH₃COO-, which is a product formed during curing of the tie coat. The acetate ion has to be destroyed during the process; the humidity contained in the liner participating in this hydrolysis of the acetate ion. The property of the clay coated removable liner is important as it is well-known that the kinetic and the post curing of the last deposit comprising the fouling release top coat is affected by the presence of the acetate ion. Now, it has been observed that the humidified paper liner reduces the amount of residual acetic acid in the tie coat and thus advantageously enables to restore a good curing kinetic of the fouling release top coat. Indeed, in preferred embodiments, during curing of the tie coat, the film comprising layers shown in Fig. 4 (i.e. a removable underlying liner (i), an adhesive layer (ii), a synthetic material layer (iii) and an intermediate silicone tie coat (iv)) is wound into a roll so that layer (iv) comes into contact with layer (i) which may reduce the amount of acetate. When the roll is unwound, the fouling release top coat (v) may be coated on the tie coat layer (iv) which has a reduced amount of acetic acid. When a siliconized synthetic or polyethylene paper is used as removable liner, the acetate ion is not hydrolyzed when the film illustrated in Fig 4 is wound into a roll, which will slow down curing of the fouling release top coat (v) which is not dry after the process step and may give some variations of thickness of the fouling release top coat (v) by deepness in the roll.

In preferred embodiments, the weight of the removable liner is 15 g/m² or more, more preferably 25 g/m² or more and even more preferably from 40 to 200 g/m².

When the weight is within the range, the removability of the removable liner from the adhesive layer is satisfactory and enables a good working efficiency. When the weight is lower than 15g/m², it becomes difficult to remove it, because of tearing of the removable liner, which may result in some parts of the liner that stay on the adhesive layer.

In preferred embodiments, the strength of adhesion of the removable liner between the removable liner and the adhesive layer is 150g/25mm or less, more preferably 80g/25mm or less and even more preferably 60g/25mm or less, When the strength of adhesion is within the range, the removability of the removable liner from the adhesive layer is satisfactory and enables a good working efficiency. When the strength of adhesion is higher than 150g/25mm, it becomes difficult to remove it because of tearing of the removable liner, which may result in some parts of the liner that stay on the adhesive layer.

### Adhesive layer

The adhesive layer (ii) is capable of securing the multilayer self-adhesive fouling release film with textured surface to a desired location. Conventional adhesives include notably pressure sensitive adhesives (PSA).

The pressure sensitive adhesives (PSA) can be any pressure sensitive adhesive having at least the following characteristics: (a) is capable of creating lasting adhesion to the material to be coated, such as the ship hull material, and the synthetic material layer of the present invention, for at least five years; (b) is resistant to marine conditions.

In a preferred embodiment, a PSA for the adhesive layer (ii) is defined to insure the optimal properties for the present invention. The material used for such application could be for example acrylic PSA resin, epoxy PSA resin, amino based PSA resin, vinyl based PSA, silicone based PSA resin, a rubber-based PSA adhesive, etc. In preferred embodiments, the PSA is a solvent based acrylic adhesive, more preferably a solvent based acrylic adhesive resistant to water and allowing an application at low temperatures from -10 °C to 60 °C and more preferably from 3 °C to 30 °C. This characteristic should permit an application during all the year.

PSA based on acrylic acid polymers, notably comprising an acrylic polymer and a cross-linking agent are particularly suitable. Examples of such acrylic polymers are polymers formed from monomeric acrylic acid and/or an acrylic ester. A polymerizing agent starts the polymerization by forming free radicals which attack the double bonds in said monomeric acrylic acid and/or acrylic acid compounds. The polymerization is stopped either by an inhibitor or by a recombination of radicals. In a further step, the polymer is cross-linked to improve its internal strength (cohesion). A suitable cross-linking agent includes an isocyanate crosslinker. In other embodiments, the cross-linking agent includes a metal organic curing agent, an isocyanate curing agent or others.

Example of metal cross-linking agent:

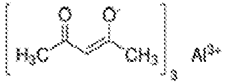

The cross-linking process of acrylic copolymer by metal chelate agents is well known and widely described in the literature (see for example Zbigniew Czech, Marta Wojciechowicz, "The crosslinking reaction of acrylic PSA using chelate metal acetylacetonates", European Polymer Journal 42 (2006) 2153-2160.

The outer surface of the adhesive layer may be covered with a removable liner which is released prior to application.

In preferred embodiments, the layer will generally have a thickness between 5 µm and 250 µm, and more preferably between 60 µm and 150 µm depending on the type of adhesive used and the application envisaged.

### Synthetic material layer

A layer of synthetic material, or synthetic material layer, allowing to coat an optional tie coat layer on one side, and the adhesive layer on the other side. The synthetic material has preferably excellent properties of impermeability, water resistance, flexibility and elongation. In preferred embodiments, the polymeric material for the synthetic material layer includes polyvinylchloride, a vinylchloride resin, a polyvinylchloride resin, a polyurethane resin, a polyurethane acrylic resin, a vinyl chloride resin, a rubber-based resin, a polyester resin, a silicone resin, an elastomer resin, a fluoro resin, nylon, a polyamide resin and/or a polyolefin resin, such as polypropylene and polyethylene. Such materials for the synthetic material layer may be present in one sub-layer or may be present in two sub-layers or more. The nature and components of each of said sub-layers can bring additional anchorage and barrier properties to the synthetic material layer,

When the synthetic material layer contains an elastomer, the elastomer is preferably an olefin-based elastomer. In preferred embodiments, the olefin-based elastomer is a polypropylene-based elastomer. In preferred embodiments, said polypropylene-based elastomer is selected from the group comprising non-oriented polypropylene, mono-oriented polypropylene, bi-oriented polypropylene and blown polypropylene, or any combination thereof. It is well-known that elastomers possess the mechanical property to undergo elastic deformation under stress with the material returning to its previous size without permanent deformation. The use of an olefin-based elastomer can thus provide a multilayer self-adhesive fouling release film with textured surface that can be applied on a flat and curved surface with good workability without wrinkles formation. Said polypropylene-based elastomer further allows a good anchorage on the adhesive layer, the optional tie coat and, when the optional tie coat is not present, on the top coat. By good anchorage of layers is meant that the adhesive layer and the synthetic material layer, the synthetic material layer and the tie coat and, when the optional tie coat is not present, the synthetic material layer and top coat do not split up during the period and under the conditions of intended product use.

In preferred embodiments, to further ameliorate the anchorage of said synthetic material layer, the synthetic material layer is treated on one or both of its sides. In preferred embodiments, said synthetic material layer is treated on one or both of its sides, preferably on both of its sides, using a corona treatment or a plasma treatment, resulting in epoxy functional groups, acrylic functional groups, carboxylic functional groups, amino functional groups, urethane functional groups, and/or silicone functional groups on the surface of the synthetic material layer. In other preferred embodiments, said synthetic material layer is treated on one or both of its sides, preferably on both of its sides, by using a primer treatment. In preferred embodiments, the synthetic material layer comprises a polypropylene-based elastomer and is treated on one or both of its sides, preferably on both of its sides, with a plasma treatment using a N₂ gas, providing amide, amine and imide functional groups on one or both of the sides, preferably on both sides, of said layer. A schematic sectional view of an embodiment wherein the synthetic material layer iii is provided with functional groups F on both of its sides or surfaces, in order to increase the surface energy, is shown in Fig. 2.

If the synthetic material layer is porous to any component which could migrate and modify the original properties of the film, it could be necessary to adjust the synthetic material layer thickness and/or adding a barrier layer in the synthetic material layer or to its surface. The thickness of synthetic material depends on the nature of the synthetic material layer provided that the properties of the present invention are not deteriorated. In preferred embodiments, the thickness of the synthetic material layer is from 10 µm to 3000 µm, more preferably from 30 µm to 1000 µm and even more preferably from 50 µm to 300 µm. When the thickness is too low, the migration from any component coming from optional layer or layer, or a water molecule, may go through the synthetic material layer and modify the original properties of the film.

The applicant further notes that employing a 15 to 20 µm polyamide film will largely have a similar or equal barrier effect as would be achieved by employing a 100 µm polypropylene film.

### Intermediate silicone tie coat

The optional intermediate silicone tie coat layer which may be used as a bond between the synthetic material layer and the fouling release top coat. In preferred embodiments, the tie coat layer is a one component silicone system, a two components silicone system or a three components silicone system. The two latter systems are curable by an addition-type or condensation-type curing system. The composition of the tie coat layer is preferably a two components polysiloxane or a silane silicone curable by a poly-condensation system which means that the polysiloxarte or silane contains reactive groups which enable curing. In preferred embodiments, the tie coat layer is an organo functional silane having the following chemical structure:

X-CH₂CH₂CH₂Si(OR)₃₋ₙR'ₙ

where n = 0, 1, 2

The OR groups are hydrolysable groups such as, preferably, methoxy, ethoxy or acetoxy groups and more preferably acetoxy groups. The group X is preferably an organo functional group such as epoxy, amino, methacryloxy or sulfide groups, more preferably organo functional groups with the addition of an acid or an organic acid. The acid can preferably be a carboxylic acid, particularly preferably acetic acid. The addition of acid greatly increases the adhesion of a silicone elastomer as fouling release top coat.

In preferred embodiments, the thickness of the tie coat layer is preferably from 10 µm to 120 µm, more preferably from 20 µm to 80 µm and still more preferably from 30 µm to 60µm. When the value is within the range, the tie coat layer is dry after a heating step during a process for the manufacture of the film, for example, when it leaves an oven during such manufacturing process, and has a good anchorage on the synthetic material layer. It also enables to have a satisfactory anchorage of the fouling release top coat which is coated on the tie coat layer. When the thickness is higher than 120 µm, the tie coat is not dry after a heating step and the consequence is that it sticks on the removable liner when the film illustrated in Fig. 4 is wound, and then the next step, which is the coating of the fouling release top coat, cannot be done. When the thickness is lower than 20 µm, the combination of tie coat layer and fouling release top coat may be removed from the multilayer self-adhesive fouling release film with textured surface, resulting in loss of the fouling release properties.

### Silicone fouling release top coat

In preferred embodiments, the silicone fouling release top coat comprises a silicone resin. The number of kinds of silicone resins may be only one or two or more. Such silicone resin may be a condensation-type silicone resin or may be an addition-type silicone resin. In addition, the silicone resin may be a one-component silicone resin to be dried alone or a two-components silicone resin to be compounded with a curing agent. The silicone resin is preferably an elastomer silicone resin, more preferably a polysiloxane containing reactive groups which can react with a curing agent by a condensation-type reaction. This kind of silicone system gives good properties of low surface energy. Examples of poiysiloxane are polydialkylsiloxane, polydiarylsiloxane or polyalkylarylsiloxane typically of the formula: 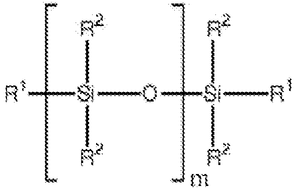 wherein each R¹ is independently selected from -H, -Cl, -F, C₁₋₄-alkyl (e.g. -CH₃, - CH₂CH₃, -CH₂CH₂CH₃, -CH(CH₃)₂, -CH₂CH₂CH₂CH₃), phenyl (-C₆H₅), and C₁₋₄-aikylcarbonyl (e.g. -C(=O)CH₃, -C(=O)CH₂CH₃ and -C(=O)CH₂CH₂CH₃), in particular -H and methyl; wherein R² is independently selected from C₁₋₁₀-alkyl (including linear or branched hydrocarbon groups) and aryl (e.g. phenyl (-C₆H₅)), in particular methyl, and wherein m is 0-5000.

In preferred embodiments, the fouling release top coat contains a fouling release agent. Any appropriate fouling release agent may be used as fouling release agent as far as the fouling release effect is not damaged. Example of such fouling release agents include, but are not limited to, silicone oil, liquid paraffin, surfactant wax, petrolatum, animal fats and fatty acid. The number of different kinds of fouling release agent may be one, two or more. When the fouling release top coat contains a fouling release agent, the surface energy of the fouling release top coat is lower and the multilayer self-adhesive fouling release film with textured surface maintains a good fouling release property for a long time period. This fouling release agent migrates to the surface of the silicone resin as matrix and covers the surface of the fouling release top coat with the fouling release component to reduce and prevent the fouling on an underwater structure by reducing the surface energy, The fouling release agent is preferably a silicone oil, more preferably a non-hydrolysable silicone oil and is preferably free of reactivity with the silicone resin. In a preferred embodiment, the silicone fouling release top coat comprises a non-hydrolysable silicone oil which is free of reactivity with the silicone of said fouling release top coat. The latter composition of the top coat is especially preferred since it allows for the fouling release effect to be maintained for a long time period. Said silicone oil is preferably composed by a homopolymer siloxane oil or a copolymer siloxane oil, such as a phenyl-methyl dimethyl siloxane copolymer and phenyl-methyl siloxane homopolymer.

In preferred embodiments, the rate of silicone oil present in the fouling release layer is from 0.1 to 150% dry weight, more preferably from 1 to 100% dry weight and still more preferably from 2 to 50% dry weight. When the value is within the range, the multilayer self-adhesive fouling release film with textured surface has good fouling release properties to reduce and prevent the fouling on an underwater structure. When the value is lower than 0.1% dry weight, the fouling release property is not achieved and the amount of fouling cannot be reduced or prevented on an underwater structure. When the value is higher, the silicone oil is released from the multilayer self-adhesive fouling release film with textured surface and may cause a problem for the anchorage of the fouling release top coat on the tie coat layer or the synthetic material layer.

In preferred embodiments, the thickness of the fouling release top coat is from 80 µm to 800 µm, more preferably from 120 to 300 µm and still more preferably from 180 to 250 µm, When the value is within the range, the fooling release top coat is dry after a heating step during a process for the manufacture of the film, for example, when it leaves an oven during such manufacturing process, and has fouling release properties to reduce and prevent the apparition of aquatic organisms on an underwater structure. When the thickness is lower than 80 µm, the fouling release property may not be sufficient to reduce and prevent the apparition of aquatic organisms on and underwater structure, which will increase the water friction and reduce the speed and maneuverability of said underwater structure.

### Removable polymeric film

The removable polymeric film is to be removed notably once the adhesive layer of the multilayer film has been applied over a substrate to be coated. In a preferred embodiment, the removable polymeric film is present in a multilayer film according to an embodiment of the second aspect of the present invention.

The removable polymeric film is embossed with the negative of the air retaining structure. And therefore, when we will apply the liquid (or semi cured) top coat, the top coat will flow inside the embossed structure of the removable polymeric film. After complete curing, the top coat will have the positive air retaining structure.

In preferred embodiments, the removable polymeric film is a polyester, polyethylene or a polypropylene film. Said film advantageously prevents the migration of silicone and/or exuding liquid up to the adhesive layer when the film comprising all six layers is wound into a roll, wherein the top coat layer would come into contact with the underlying liner when the tie coat would be absent. This is likewise the case when the film comprising adhesive layer, synthetic material layer, optionally tie coat, top coat and removable polymeric film is wound into a roll, wherein the top coat would come directly into contact with the adhesive layer when the removable polymeric film would be absent. In other embodiments, the removable polymeric film comprises polyvinylidene fluoride, polyurethane, polyvinylchloride or another material.

The removable polymeric film has possibly one function or more, preferably two functions or more. One function could be the protection of the top coat from scratch and scuff during the manipulation and the application. The removable polymeric film of the multilayer self-adhesive fouling release film with textured surface has to be removed just after the adhesive layer of the multilayer film has been applied over the surface to be coated.

A second function may be, when the multilayer self-adhesive fouling release film is wound into a roll, to prevent the migration of components from the tie coat and top coat layers through the removable underlying liner which could modify the original properties of the multilayer film.

In a preferred embodiment an air-retaining layer according to the invention is provided with protruding elements and/or ribs which are compartmentalized or grouped by surrounding walls for an improved air-retaining as schematically depicted in Fig.10, Fig.11 and Fig. 12. These surrounding walls can have a regular or irregular closed pattern. This compartmentalization of the protrusions provides for an additional air-retaining effect especially in sea-circumstances and at higher velocity of the vessels.

The invention is further described by the following non-limiting examples which further illustrate the invention, and are not intended to, nor should be interpreted to limit the scope of the invention,

### EXAMPLES

### EXAMPLE 1

Example 1 relates to a preferred embodiment of an air-retaining film with textured surface. According to Example 1, the air-retaining film comprises a silicone air-retaining layer and a polypropylene, polyethylene or polyester removable polymeric film, The silicone air-retaining layer is provided with a liquid-facing side to be contacted with liquid in use, the liquid-facing side comprising a surface morphology with spaced protruding elements whose surfaces are hydrophobic at least regionally, and which protruding elements are arranged with regard to each other and of such dimensions to enable air to be trapped and retained between the protruding elements when the air-retaining layer is immersed and subject to flow in a liquid, e.g. in water. The removable polymeric film comprises an embossed surface, which embossed removable polymeric film is applied along said surface over and to the liquid-facing side of the air-retaining layer, wherein said embossed surface is a negative of the surface morphology of the liquid-facing side of the air-retaining layer. The removable polymeric film serves to protect the liquid-facing side from damaging, scratch and/or scuff during storage and during manipulation of the liquid-facing side of the air-retaining layer when being coated to an underwater surface of a ship, vessel or similar substrate in order to obtain drag reduction for said ship, vessel or similar substrate while sailing in a water way, channel or sea. The removable polymeric film can be removed after coating of the air-retaining layer, along a side opposite to the liquid-facing side, on the underwater surface of a ship, vessel or similar substrate, in order to obtain drag reduction by the air trapped in the air-retaining layer, since the entrapped air forms a thin air layer which keeps a liquid, e.g. water, from coming into contact with the air-retaining film and thus with the ship, vessel or similar substrate. Said air layer also serves to prevent fouling or release fouling, e.g. underwater organisms, from adhering to outside structures, e.g. a hull, of said ship, vessel or similar substrate while at rest. Accordingly, it can also be used for preventing attachment of fouling with underwater organisms on surfaces of stationary structures, such as piers and caissons.

In particular, the protruding elements are spaced from another according to a distance of 1 to 12 µm, and each protruding element has a height of 2 to 24 µm, and each protruding element has a width of 1 to 12 µm. Such dimensions and spacing of the protruding elements of the silicone air-retaining layer, together with the, at least regionally, hydrophobic nature of the protruding elements is especially suitable for trapping and retaining air between the protruding element, and thus for performing said drag reduction and fouling release properties. The air-retaining film according to Example 1 is able to provide a 15-25% drag reduction of ship, vessels or similar substrates by the air layer formed by the air entrapped and retained by the air-retaining layer.

### EXAMPLE 2

Example 2 relates to a preferred embodiment of an air-retaining film with textured surface which corresponds to the preferred embodiment of an air-retaining film according to Example 1, except that the film according to Example 2 comprises additional layers. The additional layers serve to provide the air-retaining film with an adhesion means on a side opposite to the liquid-facing side of the silicone air-retaining layer of the air-retaining film, so that the air-retaining film may be coated on an underwater surface of a ship, vessel or similar substrate without needing separately applied adhesion means.

The air-retaining film with textured surface 1 according to the preferred embodiment of Example 2, as shown in Fig. 1, additionally comprises:
- a removable underlying liner i;
- an adhesive layer ii, applied over and to the underlying liner i;
- a synthetic material layer iii applied over and to the adhesive layer ii;
- an intermediate silicone tie coat iv which is a one component silicone system, a two components silicone system or a three components silicone system, applied over and to the synthetic material layer iii.

A side of the air-retaining layer v opposite to the liquid-facing side 2 is applied over and to the intermediate silicone tie coat iv. The removable polymeric film vi is applied along its embossed surface over and to the liquid-facing side 2 of the air-retaining layer v. Protruding elements 3, their heights H1 and widths W1 and the distances D1 between adjacent protruding elements are clearly shown in Fig. 1. A multilayer film as shown in Fig. 1 is ideally suited for providing the silicone air-retaining film 1 with a well-connected adhesive layer ii, which adhesive layer ii is optimally suited for adhesion of the air-retaining film on an underwater surface of a ship, vessel, or similar substrate to be coated.

The removable underlying liner i of the air-retaining film with textured surface 1 is to be removed prior to coating of the film with textured surface 1 with its adhesive layer ii on underwater surfaces of ships, vessels or similar substrates. The removable polymeric film vi is removed once the film with textured surface 1 has been coated on said underwater surfaces. An air-retaining film with textured surface 1 which is used as a coating on such underwater surface is schematically shown in Fig. 3.

### EXAMPLE 3

Example 3 relates to a preferred embodiment of an air-retaining film with textured surface which corresponds to the preferred embodiment of an air-retaining film according to Example 1, except that for the silicone air-retaining layer, the protruding elements comprise a hydrophobic body and a hydrophilic end. Suitable materials for such air-retaining layer comprising hydrophobic bodies and hydrophilic ends are a silicone derivative with hydrophilic groups as material for the hydrophilic ends and a silicone (hydrophobic) material which forms the material for the remainder of the protruding elements. Said silicone derivative with hydrophilic groups may comprise both hydrophilic and hydrophobic groups and could be a dimethylsiloxane backbone in which some of the methyl groups are replaced by polyalkylenoxy or pyrrolidone groups with a propyl group as a spacer. Also, such silicone derivative could be used to form the entire protruding elements, if hydrophilic groups of such silicone derivative are located at said hydrophilic end while hydrophobic groups are located at said hydrophobic body. Since air is hydrophobic, the air prefers to reside near the hydrophobic body and away from the hydrophilic end. This will reduce the risk of losing entrapped air, and thus improves the air retention by the protruding elements.

### EXAMPLE 4

Example 4 relates to a preferred embodiment of an air-retaining film with textured surface which corresponds to the preferred embodiment of an air-retaining film 1 according to Example 3, except that the film according to Example 3 comprises additional layers i, ii, iii, iv, as shown in Fig. 5, For the purpose, advantages, description and technical effects of said additional layers is referred to Example 2.

Please note that Fig. 5 clearly shows the removable polymeric film vi which is applied along its embossed surface over and to the liquid-facing side 2 of the air-retaining layer v. Protruding elements 3 comprising hydrophobic bodies 3a and hydrophilic ends 3b, their heights H1 and widths W1 and the distances D1 between adjacent protruding elements are also clearly shown in Fig. 5,

Fig. 6 schematically shows an air-retaining film with textured surface 1 according to Example 4 which is used as a coating on such underwater surface.

### EXAMPLE 5

Example 5 relates to a preferred embodiment of method steps for producing an air-retaining film with textured surface 1, the air-retaining film 1 comprising an air-retaining layer v provided with a liquid-facing side 2 to be contacted with liquid in use, the liquid-facing side 2 comprising a surface morphology with spaced protruding elements 3 whose surfaces are hydrophobic at least regionally, as shown in Fig. 7.

At start of the method according to Example 5, a Si metallic panel 8 is provided, which Si metallic panel 8 comprises a surface comprising a surface morphology with protrusions 6a, which surface morphology is a negative of the surface morphology of the liquid-facing side 2 of the air-retaining layer v. Said surface of the Si metallic panel 8 is structured by lithography. A Si metallic panel 8 shows the advantage of being able to be structured, by lithography according to this example, very finely, which is required as a basis for finally acquiring a surface morphology of the liquid-facing side 2 with its very small dimensions, which small dimensions are for example described in Example 1,

In step I, a silicone or rubber mold 9 is formed by casting liquid silicone onto the Si metallic panel, the resulting silicone or rubber mold 9 comprising a surface comprising a surface morphology with protrusions 5, which surface morphology is identical to said surface morphology of the liquid-facing side 2 of the air-retaining layer v. The resulting silicone or rubber mold 9 possesses a surface morphology with protrusions 5 of very small dimensions, which was possible by starting from the Si metallic panel. The silicone or rubber mold 9 on its turn shows the advantages that due to its flexibility, it is easily maneuverable and can rather easily be removed from a synthetic material, such as a polymeric material, e.g. polypropylene, polyethylene or polyester, which is embossed by it.

In step II, said silicone or rubber mold 9 is mounted onto a cylinder 4, with the advantage that embossing of a material by the silicone or rubber mold 9 can be performed relatively fast by rotating the cylinder 4, and if desired can be relatively easy be performed in a continuous manner.

In step III, a removable polymeric film vi, which may be a polypropylene, polyethylene or polyester film, is created by extruding the removable polymeric film vi on the silicone or rubber mold 9 while the silicone or rubber mold 9 is moved by rotating the cylinder 4, wherein a resulting embossed surface of the removable polymeric film vi, with protrusions 6b, is a negative of the surface morphology of the liquid-facing side 2 of the air-retaining layer v to be produced. When releasing the removable polymeric film vi, the silicone or rubber mold can absorb part of the energy, which avoids breaking of the removable polymeric film when being embossed. The removable polymeric film vi shows the advantages that it can be used to form the surface morphology of the liquid-facing side 2 of the air-retaining layer v to be produced, and that it functions as an excellent protective layer of the air-retaining layer v before it is applied for its intended use.

In step IV, the embossed surface of the removable polymeric film vi is laminated onto a side of an at least regionally hydrophobic curable material layer which is at a liquid or semi-cured stage, the lamination step shaping the curable material layer into an air-retaining layer v with a liquid-facing side 2 comprising a surface morphology with spaced protruding elements 3 whose surfaces are hydrophobic at least regionally, Using a removable polymeric film vi comprising an embossed surface for providing a surface morphology of the air-retaining layer v comprising protruding elements 3 promotes a stable formation of said protruding elements 3 while shielding the protruding elements 3 from an environment until the air-retaining film with textured surface 1 is prepared for use by removing the removable polymeric film vi. This ensures a well-defined formation of protruding elements 3 and a highly textured surface morphology of the air-retaining layer v which is beneficial for reasons of drag reduction and fouling release.

In step V, the thus formed air-retaining film with silicone air-retaining layer v and removable polymeric film vi is laminated onto an assembly of removable underlying liner i, adhesive layer ii, synthetic material layer iii and intermediate silicone tie coat iv, by laminating a side of the silicone air-retaining layer v opposite to its liquid-facing side 2, while the air-retaining layer v is still in a semi-cured stage onto the intermediate silicone tie coat iv, also preferably in a semi-cured stage. Afterwards, the obtained product can be cured in an oven. The addition of additional layers according to step V shows the advantage that the silicone air-retaining film 1 is provided with a well-connected adhesive layer ii, which adhesive layer ii is optimally suited for adhesion of the air-retaining film 1 on an underwater surface of a ship, vessel, or similar substrate to be coated.

### EXAMPLE 6

Example 6 relates to a preferred embodiment of an air-retaining film with textured surface which corresponds to the preferred embodiment of an air-retaining film according to Example 1, except that the film according to Example 6 comprises ribs on the liquid-facing side of the air-retaining layer and in between the protruding elements, said ribs having a height, and wherein a ratio of said rib height and the height of a protruding element is at least 2:1. The ribs impair adherence of underwater organisms to the air-retaining layer, thus improving fouling release by the film and avoiding increased drag in time. At the same time, due to its structure, the textured surface morphology of the ribs itself provides an increased drag reduction.

### EXAMPLE 7

Example 7 relates to a preferred embodiment of an air-retaining film with textured surface which corresponds to the preferred embodiment of an air-retaining film 1 according to Example 6, except that the film according to Example 6 comprises additional layers i, ii, iii, iv, as shown in Fig. 8. For the purpose, advantages, description and technical effects of said additional layers is referred to Example 2.

Please note that Fig. 8 clearly shows the removable polymeric film vi which is applied along its embossed surface over and to the liquid-facing side 2 of the air-retaining layer v. Protruding elements 3 comprising hydrophobic bodies 3a and hydrophilic ends 3b, their heights H₁ and widths W₁ and the distances D₁ between adjacent protruding elements are also clearly shown in Fig. 8. Fig, 8 also clearly shows the ribs 7 on the liquid-facing side of the air-retaining layer v and in between the protruding elements 3, said ribs 7 are spaced from another according to a distance D₂ which is preferably 60 to 310 pm, said ribs 7 having a height H₂, and wherein a ratio of said rib height H₂ and the height H₁ of a protruding element 3 is at least 2:1, preferably at least 3:1, Said ribs 7 have a width W₂, wherein rib width W₂ and rib height H₂ relate preferably according to a ratio from 1:50 to 1:1, Each rib 7 shows an opening angle of preferably of 25 to 35°. Tops of adjacent rib 7 are spaced according to a dimension D₂,

### EXAMPLE 8

Example 8 relates to a preferred embodiment of an air-retaining film with textured surface which corresponds to the preferred embodiment of an air-retaining film according to Example 3, except that the film according to Example 8 comprises ribs on the liquid-facing side of the air-retaining layer and in between the protruding elements which comprise hydrophobic bodies and hydrophilic ends, said ribs having a height, and wherein a ratio of said rib height and the height of a protruding element is at least 2:1, preferably at least 3:1. The ribs impair adherence of underwater organisms to the air-retaining layer, thus improving fouling release by the film and avoiding increased drag in time. At the same time, due to its structure, the textured surface morphology of the ribs itself provides an increased drag reduction.

### EXAMPLE 9

Example 9 relates to a preferred embodiment of an air-retaining film with textured surface 1 which corresponds to the preferred embodiment of an air-retaining film 1 according to Example 8, except that the film according to Example 9 comprises additional layers i, ii, iii, iv, as shown In Fig. 9. For the purpose, advantages, description and technical effects of said additional layers is referred to Example 2.

Please note that Fig. 9 clearly shows the protruding elements 3 comprising hydrophobic bodies 3a and hydrophilic ends 3b,

## Claims

1. A method for producing an air-retaining film (1) with textured surface, the air-retaining film (1) comprising an air-retaining layer (v) provided with a liquid-facing side (2) to be contacted with liquid in use, the liquid-facing side (2) comprising a surface morphology with spaced protruding elements (3) whose surfaces are hydrophobic at least regionally, wherein the method comprises the step of laminating an embossed surface of an embossed removable polymeric film (vi) onto a side of an at least regionally hydrophobic curable material layer which is at a liquid or semi-cured stage, wherein said embossed surface is a negative of the surface morphology of the liquid-facing side (2) of the air-retaining layer (v) to be produced, the lamination step shaping the curable material layer into an air-retaining layer (v) with a liquid-facing side (2) comprising said surface morphology and wherein before the lamination step, the method comprises the step of embossing an removable polymeric film to provide said embossed removable polymeric film (vi), which embossing is performed by extruding the removable polymeric film on a silicone or rubber mold (9) with a surface comprising a surface morphology which is identical to said surface morphology of the liquid-facing side (2) of the air-retaining layer (v), **characterized in that** adjacent protruding elements (3) are spaced from another according to a distance (D1) of 0.01 to 3000 µm, preferably 0.1 to 1000 µm, **in that** a protruding element (3) has a height (H1) and a ratio of said height (H1) and said distance (D1) is from 1:3 to 3:1, and **in that** a protruding element (3) has a width (W1) and a ratio of said width (W1) and said distance (D1) is from 1:3 to 3:1, more preferably from 1:2 to 2:1, even more preferably from 1:1.5 to 1.5:1, and yet even more preferably from 1:1.2 to 1.2:1 and wherein within the surface morphology of the liquid-facing side (2) of the air-retaining layer (v), the height (H1) of adjacent protruding elements (3) decreases along a rectilinear direction.

2. Method according to claim 1, wherein said at least regionally hydrophobic curable material layer comprises silicone and/or silicone derivatives.

3. Method according to claim 1 or 2, wherein said embossed removable polymeric film (vi) is a polypropylene, polyethylene or polyester film.

4. Method according to claim 1 to 3, wherein said silicone or rubber mold (9) is mounted onto a cylinder (4).

5. Method according to claim 1 to 4, wherein before the step of embossing the removable polymeric film, the method comprises the step of forming said silicone or rubber mold (9), which is performed by casting liquid silicone onto a metallic panel (8) with a surface comprising a surface morphology which is a negative of the surface morphology of the liquid-facing side (2) of the air-retaining layer (v), and wherein said surface of the metallic panel (8) is structured by lithography.

6. Method according to claim 5, wherein the metallic panel (8) is a Si metallic panel (8).

7. An air-retaining film (1) with textured surface, the air-retaining film (1) comprising an air-retaining layer (v) provided with a liquid-facing side (2) to be contacted with liquid in use, the liquid-facing side (2) comprising a surface morphology with spaced protruding elements (3) whose surfaces are hydrophobic at least regionally, wherein adjacent protruding elements (3) are spaced from another according to a distance (D1) of 0.01 to 3000 µm, preferably 0.1 to 1000 µm, in that a protruding element (3) has a height (H1) and a ratio of said height (H1) and said distance (D1) is from 1:3 to 3:1, and in that a protruding element (3) has a width (W1) and a ratio of said width (W1) and said distance (D1) is from 1:3 to 3:1, more preferably from 1:2 to 2:1, even more preferably from 1:1.5 to 1.5:1, and yet even more preferably from 1:1.2 to 1.2:1, wherein the air-retaining film (1) comprises an embossed removable polymeric film (vi) comprising an embossed surface, which polymeric film (vi) is applied along said surface over and to the liquid-facing side (2) of the air-retaining layer (v), wherein said embossed surface is a negative of the surface morphology of the liquid-facing side (2) of the air-retaining layer (v) and wherein the air-retaining layer (v) and/or the embossed removable polymeric film (vi) are obtained by performing a method according to any of claims 1 to 6 and wherein within the surface morphology of the liquid-facing side (2) of the air-retaining layer (v), the height (H1) of adjacent protruding elements (3) decreases along a rectilinear direction.

8. Air-retaining film (1) with textured surface according to claim 7, wherein the air-retaining layer (v) comprises silicone and/or silicone derivatives.

9. Air-retaining film (1) with textured surface according to any of claims 7 or 8, wherein one or more of said protruding elements (3) comprise a hydrophobic body (3a) and a hydrophilic end (3b).

10. Air-retaining film (1) with textured surface according to any of claims 7 to 9, wherein ribs (7) are provided on the liquid-facing side (2) of the air-retaining layer (v) and in between the protruding elements (3), said ribs (7) having a height (H2), and wherein a ratio of said rib height (H2) and the height (H1) of a protruding element (3) is at least 1,5:1, more preferably at least 1,8:1 and even more preferably at least 2:1, and most preferably at least 3:1.

11. Air-retaining film (1) with textured surface according to any of claims 7 to 10, wherein the air-retaining film (1) further comprises:
an optional removable underlying liner (i);
an adhesive layer (ii), applied over and to the optional underlying liner (i) when present;
a synthetic material layer (iii) applied over and to the adhesive layer (ii); and
optionally, an intermediate silicone tie coat (iv) which is a one component silicone system, a two components silicone system or a three components silicone system, applied over and to the synthetic material layer (iii),
and wherein a side of the air-retaining layer (v) opposite to the liquid-facing side (2) is applied over and to the synthetic material layer (iii), or, when present, to the intermediate silicone tie coat (iv).

12. Air-retaining film (1) with textured surface according to any of claims 7 to 11, wherein several protruding elements (3) are compartmentalized or grouped by surrounding walls, which walls can have a regular or irregular pattern for an improved air-retaining capacity.

## Patentansprüche

1. Verfahren zur Herstellung eines Lufthaltefilms (1) mit strukturierter Oberfläche, wobei der Lufthaltefilm (1) eine Lufthalteschicht (v) umfasst, die mit einer zur Flüssigkeit weisenden Seite (2) ausgestattet ist, um bei Gebrauch mit Flüssigkeit kontaktiert zu werden, wobei die zur Flüssigkeit weisende Seite (2) eine Oberflächenmorphologie mit beabstandeten vorspringenden Elementen (3) umfasst, deren Oberflächen mindestens regional hydrophob sind, wobei das Verfahren den Schritt des Laminierens einer geprägten Oberfläche eines geprägten entfernbaren polymeren Films (vi) auf eine Seite einer mindestens regional hydrophoben härtbaren Materialschicht umfasst, die sich in einem flüssigen oder halbgehärteten Stadium befindet, wobei die geprägte Oberfläche ein Negativ der Oberflächenmorphologie der zur Flüssigkeit weisenden Seite (2) der herzustellenden Lufthalteschicht (v) ist, der Laminierungsschritt die härtbare Materialschicht zu einer Lufthalteschicht (v) mit einer zur Flüssigkeit weisenden Seite (2) formt, welche die Oberflächenmorphologie umfasst, und wobei das Verfahren vor dem Laminierungsschritt den Schritt des Prägens eines entfernbaren polymeren Films umfasst, um den geprägten entfernbaren polymeren Film (vi) bereitzustellen, wobei das Prägen durchgeführt wird, indem der entfernbare polymere Film auf eine Silikon- oder Kautschukform (9) mit einer Oberfläche extrudiert wird, die eine Oberflächenmorphologie umfasst, die mit der Oberflächenmorphologie der zur Flüssigkeit weisenden Seite (2) der Lufthalteschicht (v) identisch ist, **dadurch gekennzeichnet, dass** benachbarte vorspringende Elemente (3) voneinander um einen Abstand (D1) von 0,01 bis 3000 pm, vorzugsweise 0,1 bis 1000 µm beabstandet sind, dass ein vorspringendes Element (3) eine Höhe (H1) hat, und ein Verhältnis der Höhe (H1) zu dem Abstand (D1) 1:3 bis 3:1 beträgt, und dass ein vorspringendes Element (3) eine Breite (W1) hat, und ein Verhältnis der Breite (W1) zu dem Abstand (D1) 1:3 bis 3:1, bevorzugter 1:2 bis 2:1 und noch bevorzugter 1:1,5 bis 1,5:1 und noch bevorzugter 1:1,2 bis 1,2:1 beträgt, und wobei die Höhe (H1) von benachbarten vorspringenden Elementen (3) innerhalb der Oberflächenmorphologie der zur Flüssigkeit weisenden Seite (2) der Lufthalteschicht (v) entlang einer geradlinigen Richtung abnimmt.

2. Verfahren nach Anspruch 1, wobei die mindestens regional hydrophobe härtbare Materialschicht Silikon und/oder Silikonderivate umfasst.

3. Verfahren nach Anspruch 1 oder 2, wobei der geprägte entfernbare polymere Film (vi) ein Polypropylen-, Polyethylen- oder Polyesterfilm ist.

4. Verfahren nach Anspruch 1 bis 3, wobei die Silikon- oder Kautschukform (9) auf einen Zylinder (4) montiert wird.

5. Verfahren nach Anspruch 1 bis 4, wobei das Verfahren vor dem Schritt des Prägens des entfernbaren polymeren Films den Schritt des Bildens der Silikon- oder Kautschukform (9) umfasst, der durch Gießen von flüssigem Silikon auf eine Metallplatte (8) mit einer Oberfläche durchgeführt wird, welche eine Oberflächenmorphologie umfasst, die ein Negativ der Oberflächenmorphologie der zur Flüssigkeit weisenden Seite (2) der Lufthalteschicht (v) ist, und wobei die Oberfläche der Metallplatte (8) durch Lithographie strukturiert wird.

6. Verfahren nach Anspruch 5, wobei die Metallplatte (8) eine Si-Metallplatte (8) ist.

7. Lufthaltefilm (1) mit strukturierter Oberfläche, wobei der Lufthaltefilm (1) eine Lufthalteschicht (v) umfasst, die mit einer zur Flüssigkeit weisenden Seite (2) ausgestattet ist, die bei Gebrauch mit Flüssigkeit kontaktiert werden soll, wobei die zur Flüssigkeit weisende Seite (2) eine Oberflächenmorphologie mit beabstandeten vorspringenden Elementen (3) umfasst, deren Oberflächen mindestens regional hydrophob sind, wobei benachbarte vorspringende Elemente (3) voneinander um einen Abstand (D1) von 0,01 bis 3000 pm, vorzugsweise 0,1 bis 1000 µm beabstandet sind, wobei ein vorspringendes Element (3) eine Höhe (H1) hat, und ein Verhältnis der Höhe (H1) zu dem Abstand (D1) 1:3 bis 3:1 beträgt, und wobei ein vorspringendes Element (3) eine Breite (W1) hat, und ein Verhältnis der Breite (W1) zu dem Abstand (D1) 1:3 bis 3:1, bevorzugter 1:2 bis 2:1 und noch bevorzugter 1:1,5 bis 1,5:1 und noch bevorzugter 1:1,2 bis 1,2:1 beträgt, wobei der Lufthaltefilm (1) einen geprägten entfernbaren polymeren Film (vi) umfasst, der eine geprägte Oberfläche umfasst, wobei der polymere Film (vi) entlang der Oberfläche über und auf die zur Flüssigkeit weisende Seite (2) der Lufthalteschicht (v) aufgebracht wird, wobei die geprägte Oberfläche ein Negativ der Oberflächenmorphologie der zur Flüssigkeit weisenden Seite (2) der Lufthalteschicht (v) ist, und wobei die Lufthalteschicht (v) und/oder der geprägte entfernbare polymere Film (vi) mittels Durchführen eines Verfahrens nach einem der Ansprüche 1 bis 6 erhalten wird/werden, und wobei innerhalb der Oberflächenmorphologie der zur Flüssigkeit weisenden Seite (2) der Lufthalteschicht (v) die Höhe (H1) von benachbarten vorspringenden Elemente (3) entlang einer geradlinigen Richtung abnimmt.

8. Lufthaltefilm (1) mit strukturierter Oberfläche nach Anspruch 7, wobei die Lufthalteschicht (v) Silikon und/oder Silikonderivate umfasst.

9. Lufthaltefilm (1) mit strukturierter Oberfläche nach einem der Ansprüche 7 oder 8, wobei ein oder mehrere der vorspringenden Elemente (3) einen hydrophoben Körper (3a) und ein hydrophiles Ende (3b) umfasst/umfassen.

10. Lufthaltefilm (1) mit strukturierter Oberfläche nach einem der Ansprüche 7 bis 9, wobei auf der zur Flüssigkeit weisenden Seite (2) der Lufthalteschicht (v) und zwischen den vorspringenden Elementen (3) Rippen (7) bereitgestellt werden, wobei die Rippen (7) eine Höhe (H2) haben, und wobei ein Verhältnis der Rippenhöhe (H2) zu der Höhe (H1) eines vorspringenden Elements (3) mindestens 1,5:1, bevorzugter mindestens 1,8:1 und noch bevorzugter mindestens 2:1 und am meisten bevorzugt mindestens 3:1 beträgt.

11. Lufthaltefilm (1) mit strukturierter Oberfläche nach einem der Ansprüche 7 bis 10, wobei der Lufthaltefilm (1) des Weiteren umfasst:
einen optionalen entfernbaren darunter liegenden Liner (i);
eine Klebeschicht (ii), die über und auf dem optionalen darunter liegenden Liner (i), wenn vorhanden, aufgebracht ist;
eine synthetische Materialschicht (iii), die über und auf der Klebeschicht (ii) aufgebracht ist; und
gegebenenfalls eine intermediäre Silikonverankerungsschicht (iv), die ein Einkomponenten-Silikonsystem, ein Zweikomponenten-Silikonsystem oder ein Dreikomponenten-Silikonsystem ist, das über und auf der synthetischen Materialschicht (iii) aufgebracht ist,
und wobei eine Seite der Lufthalteschicht (v) gegenüber der zur Flüssigkeit weisenden Seite (2) über und auf der synthetischen Materialschicht (iii) oder, wenn vorhanden, auf der intermediären Silikonverankerungsschicht (iv) aufgebracht ist.

12. Lufthaltefilm (1) mit strukturierter Oberfläche nach einem der Ansprüche 7 bis 11, wobei mehrere vorspringende Elemente (3) durch umliegende Wände abgeteilt oder gruppiert sind, wobei die Wände für verbesserte Lufthaltekapazität ein reguläres oder irreguläres Muster haben können.

## Revendications

1. Procédé pour la production d'un film de rétention d'air (1) doté d'une surface texturée, le film de rétention d'air (1) comprenant une couche de rétention d'air (v) pourvue d'un côté tourné vers un liquide (2) destiné à être en contact avec un liquide lors d'une utilisation, le côté tourné vers un liquide (2) comprenant une morphologie de surface dotée d'éléments espacés faisant saillie (3) dont des surfaces sont au moins par endroits hydrophobes, le procédé comprenant l'étape de stratification d'une surface embossée d'un film polymérique éliminable embossé (vi) sur un côté d'au moins une couche de matériau au moins par endroits hydrophobe durcissable qui est à un stade liquide ou semi-durci, ladite surface embossée étant un négatif de la morphologie de surface du côté tourné vers un liquide (2) de la couche de rétention d'air (v) devant être produite, l'étape de stratification façonnant la couche de matériau durcissable en une couche de rétention d'air (v) comportant un côté tourné vers un liquide (2) comprenant ladite morphologie de surface et, avant l'étape de stratification, le procédé comprenant l'étape d'embossage d'un film polymérique éliminable pour fournir ledit film polymérique éliminable embossé (vi), lequel embossage est réalisé par extrusion du film polymérique éliminable sur un moule (9) de silicone ou de caoutchouc comportant une surface comprenant une morphologie de surface qui est identique à ladite morphologie de surface du côté tourné vers un liquide (2) de la couche de rétention d'air (v), **caractérisé en ce que** des éléments faisant saillie (3) adjacents sont espacés l'un de l'autre selon une distance (D1) de 0,01 à 3 000 pm, préférablement de 0,1 à 1 000 pm, **en ce qu'**un élément faisant saillie (3) possède une hauteur (H1) et un rapport de ladite hauteur (H1) et de ladite distance (D1) est de 1 : 3 à 3 : 1, et **en ce qu'**un élément faisant saillie (3) possède une largeur (W1) et un rapport de ladite largeur (W1) et de ladite distance (D1) est de 1 : 3 à 3 : 1, plus préférablement de 1 : 2 à 2 : 1, encore plus préférablement de 1 : 1,5 à 1,5 : 1, et même encore plus préférablement de 1 : 1,2 à 1,2 : 1 et, à l'intérieur de la morphologie de surface du côté tourné vers un liquide (2) de la couche de rétention d'air (v), la hauteur (H1) d'éléments faisant saillie (3) adjacents diminuant le long d'une direction rectiligne.

2. Procédé selon la revendication 1, ladite couche de matériau au moins par endroits hydrophobe durcissable comprenant une silicone et/ou des dérivés de silicone.

3. Procédé selon la revendication 1 ou 2, ledit film polymérique éliminable embossé (vi) étant un film de polypropylène, de polyéthylène ou de polyester.

4. Procédé selon les revendications 1 à 3, ledit moule (9) de silicone ou de caoutchouc étant monté sur un cylindre (4).

5. Procédé selon les revendications 1 à 4, dans lequel avant l'étape d'embossage du film polymérique éliminable, le procédé comprend l'étape de formation dudit moule (9) de silicone ou de caoutchouc, qui est réalisée par coulée d'une silicone liquide sur un panneau métallique (8) doté d'une surface comprenant une morphologie de surface qui est un négatif de la morphologie de surface du côté tourné vers un liquide (2) de la couche de rétention d'air (v), et ladite surface du panneau métallique (8) étant structurée par lithographie.

6. Procédé selon la revendication 5, le panneau métallique (8) étant un panneau métallique (8) de Si.

7. Film de rétention d'air (1) doté d'une surface texturée, le film de rétention d'air (1) comprenant une couche de rétention d'air (v) pourvue d'un côté tourné vers un liquide (2) destiné à être en contact avec un liquide lors d'une utilisation, le côté tourné vers un liquide (2) comprenant une morphologie de surface dotée d'éléments espacés faisant saillie (3) dont des surfaces sont au moins par endroits hydrophobes, des éléments faisant saillie (3) adjacents étant espacés l'un de l'autre selon une distance (D1) de 0,01 à 3 000 pm, préférablement de 0,1 à 1 000 pm, en ce qu'un élément faisant saillie (3) possède une hauteur (H1) et un rapport de ladite hauteur (H1) et de ladite distance (D1) est de 1 : 3 à 3 : 1, et en ce qu'un élément faisant saillie (3) possède une largeur (W1) et un rapport de ladite largeur (W1) et de ladite distance (D1) est de 1 : 3 à 3 : 1, plus préférablement de 1 : 2 à 2 : 1, encore plus préférablement de 1 : 1,5 à 1,5 : 1, et même encore plus préférablement de 1 : 1,2 à 1,2 : 1, le film de rétention d'air (1) comprenant un film polymérique éliminable embossé (vi) comprenant une surface embossée, lequel film polymérique (vi) est appliqué le long de ladite surface sur le, et au, côté tourné vers un liquide (2) de la couche de rétention d'air (v), ladite surface embossée étant un négatif de la morphologie de surface du côté tourné vers un liquide (2) de la couche de rétention d'air (v), et la couche de rétention d'air (v) et/ou le film polymérique éliminable embossé (vi) étant obtenus en réalisant un procédé selon l'une quelconque des revendications 1 à 6 et, à l'intérieur de la morphologie de surface du côté tourné vers un liquide (2) de la couche de rétention d'air (v), la hauteur (H1) d'éléments faisant saillie (3) adjacents diminuant le long d'une direction rectiligne.

8. Film de rétention d'air (1) doté d'une surface texturée selon la revendication 7, la couche de rétention d'air (v) comprenant une silicone et/ou des dérivés de silicone.

9. Film de rétention d'air (1) doté d'une surface texturée selon l'une quelconque des revendications 7 et 8, un ou plusieurs desdits éléments faisant saillie (3) comprenant un corps hydrophobe (3a) et une extrémité hydrophile (3b).

10. Film de rétention d'air (1) doté d'une surface texturée selon l'une quelconque des revendications 7 à 9, des nervures (7) étant placées sur le côté tourné vers un liquide (2) de la couche de rétention d'air (v) et entre les éléments faisant saillie (3), lesdites nervures (7) possédant une hauteur (H2), et un rapport de ladite hauteur de nervure (H2) et de la hauteur (H1) d'un élément faisant saillie (3) étant d'au moins 1,5 : 1, plus préférablement d'au moins 1,8 : 1 et encore plus préférablement d'au moins 2 : 1, et le plus préférablement d'au moins 3 : 1.

11. Film de rétention d'air (1) doté d'une surface texturée selon l'une quelconque des revendications 7 à 10, le film de rétention d'air (1) comprenant en outre :
une doublure sous-jacente éliminable éventuelle (i) ;
une couche d'adhésif (ii), appliquée sur et à la doublure sous-jacente éventuelle (i) lorsqu'elle est présente ;
une couche de matériau synthétique (iii) appliquée sur et à la couche d'adhésif (ii) ; et
éventuellement, une couche de liaison de silicone intermédiaire (iv) qui est un système de silicone à un composant, un système de silicone à deux composants ou un système de silicone à trois composants, appliquée sur et à la couche de matériau synthétique (iii),
et, un côté de la couche de rétention d'air (v) opposé au côté tourné vers un liquide (2) étant appliqué sur et à la couche de matériau synthétique (iii), ou, lorsqu'elle est présente, à la couche de liaison de silicone intermédiaire (iv) .

12. Film de rétention d'air (1) doté d'une surface texturée selon l'une quelconque des revendications 7 à 11, plusieurs éléments faisant saillie (3) étant compartimentés ou groupés par des parois environnantes, lesquels parois peuvent avoir un motif régulier ou irrégulier pour une capacité de rétention d'air améliorée.
